Europäisches Patentamt

European Patent Office

Office européen des brevets

(19)

(11) EP 1 315 293 A2

(12) EUROPEAN PATENT APPLICATION

(43) Date of publication:
28.05.2003 Bulletin 2003/22

(51) Int Cl.⁷: H03H 3/02

(21) Application number: 02009756.4

(22) Date of filing: 30.04.2002

(84) Designated Contracting States:
AT BE CH CY DE DK ES FI FR GB GR IE IT LI LU
MC NL PT SE TR
Designated Extension States:
AL LT LV MK RO SI

(30) Priority: 13.11.2001 KR 2001070378

(71) Applicant: SAMSUNG ELECTRONICS CO. LTD.
Suwon-city, Kyounggi-do 441-742 (KR)

(72) Inventors:
• Seo, O-gween
  Yongin-city, Kyungki-do (KR)
• Jun, Chan-bong
  Seocho-gu, Seoul (KR)
• Park, Man-geum
  Kiheung-eub, Yongin-city, Kyungki-do (KR)

(74) Representative: Grünecker, Kinkeldey,
Stockmair & Schwanhäusser Anwaltssozietät
Maximilianstrasse 58
80538 München (DE)

(54) Fabrication of film bulk acoustic resonator

(57) A method of fabricating an air gap type Film Bulk Acoustic Resonator (FBAR) is provided. The FBAR fabrication method includes: (a) depositing and patterning a sub-electrode on a semiconductor substrate; (b) depositing and patterning a piezoelectric material layer on the sub-electrode; (c) depositing and patterning an upper electrode on the piezoelectric material layer; (d) forming a hole which passes through the upper electrode, the piezoelectric material layer and the sub-electrode; and (e) injecting a fluorine compound into the hole so that an air gap can be formed on the semiconductor substrate, and non-plasma etching the semiconductor substrate. Since the FBAR fabrication method does not include forming and eliminating the sacrificial layer in the fabrication process, the fabrication process is simplified. In addition, the air gap having the limitless frequency selectivity can be formed and the performance of the FBAR can be enhanced.

FIG. 2L

EP 1 315 293 A2

**Description**

BACKGROUND OF THE INVENTION

1. Field of the Invention

The present invention relates to a method of fabricating a Film Bulk Acoustic Resonator (FBAR), and more particularly, to a method of fabricating an air gap type FBAR.

2. Description of the Related Art

For a super high frequency band, a dielectric resonator, a metal cavity resonator and a piezoelectric thin film resonator (FBAR) are used. These resonators are superior in terms of a small insertion loss, a frequency characteristic or a temperature stability. However, they are too big to be implemented as a compact, light integrated circuit on a semiconductor substrate. When compared with the dielectric resonator or the metal cavity resonator, the FBAR can be manufactured to be compact and implemented on a silicon substrate or a gallium arsenic (GaAs) substrate, and has a smaller insertion loss.

A filter using the dielectric resonator, the metal cavity resonator and the FBAR resonator is one of core components necessary for a mobile communication system. Technology for the filter manufacture is indispensable to implement a compact, light and low power-consuming mobile terminal.

The dielectric filter and a Surface Acoustic Wave (SAW) filter are most widely used for Radio Frequency (RF) for mobile communication.

The dielectric filter is used as a 900 MHz filter for a mobile phone for a home use, and a 1.8 - 1.9 GHz duplex filter for PCS. It features a high dielectric ratio, a low insertion loss, stability in a high temperature, a vibration-proofness and a shock resistance. However, it is difficult to implement a compact dielectric filter as Monolithic Microwave Integrated Circuit (MMIC).

The SAW filter is smaller than the dielectric filter and processes a signal easily, and has the advantages of a simple circuit and easy mass-production. In addition, the SAW need not be adjusted. However, it is not easy to manufacture the SAW filter operating at more than a super high frequency (5 GHz or higher) band due to limitation of a manufacturing process.

The FBAR filter is differentiated from the above filters in that it can be very light and thin, and mass-produced easily by means of a semiconductor process and combined with RF active elements without any restriction.

The FBAR filter is a thin film where a cavity is caused by a piezoelectric characteristic after a piezoelectric material such as ZnO or AIN is deposited on the silicon (Si) substrate or GaAs in an RF sputtering method.

An FBAR fabrication process includes a membrane type, a brag reflector type and an air gap type.

In the membrane type fabrication method, a silicon P+ layer as an FBAR membrane is deposited on a silicon in an ionic growth method, and the opposite side of the silicon substrate is anisotropy-etched in order to cause an etching stop and form an etching cavity. Since a back etching is performed in the membrane method, a resonator may be deteriorated.

In the brag reflector type fabrication method, a material with a big acoustic impedance difference is deposited every other layer on a silicon substrate and a brag reflection is caused so that acoustic energy can be concentrated between electrode layers to generate a resonance. The brag reflector type fabrication method is disadvantageous in that it is hard to adjust the thickness of a thin film layer and a wave may be reduced due to phase change of a received wave if the thickness adjustment fails.

The air gap type FBAR fabrication method is the up-to-date technology designed to overcome the disadvantages of the two methods. In the air gap type FBAR fabrication method, a micro-machining technology is used to form a sacrificial layer on a silicon semiconductor substrate, make an air gap and generate a resonance. According to the air gap type FBAR fabrication method, the air gap prevents loss of a resonator and the processing is easy in the manufacturing process.

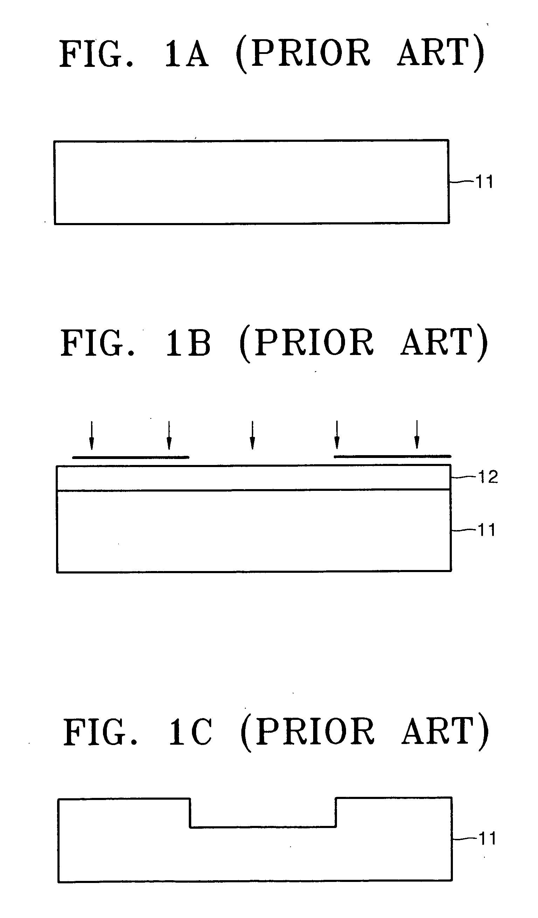

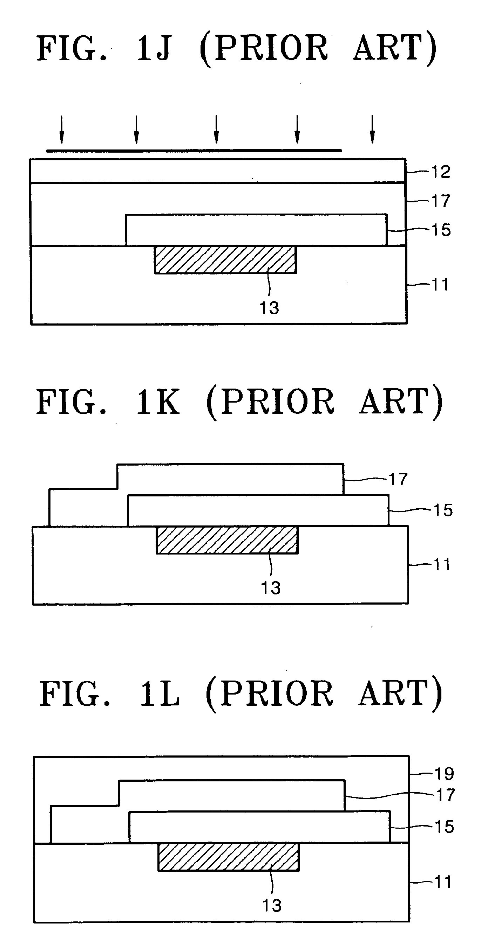

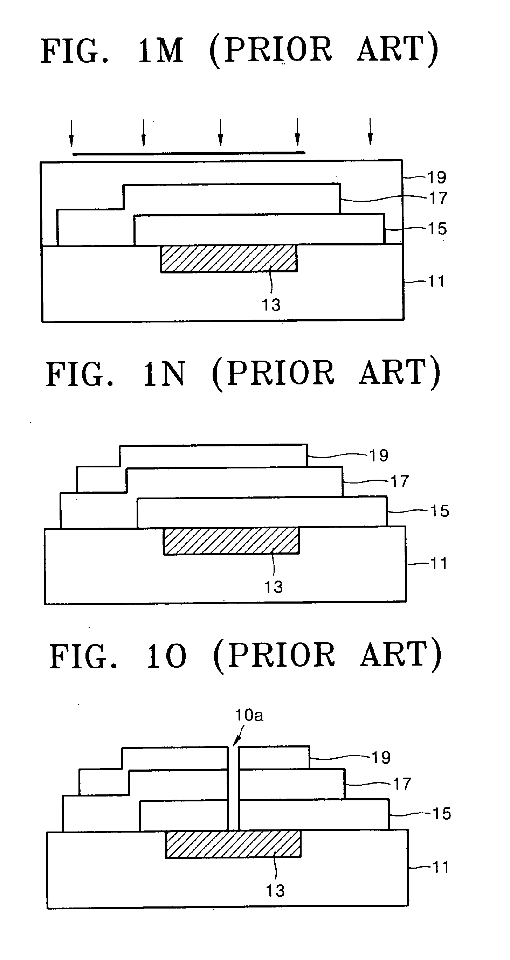

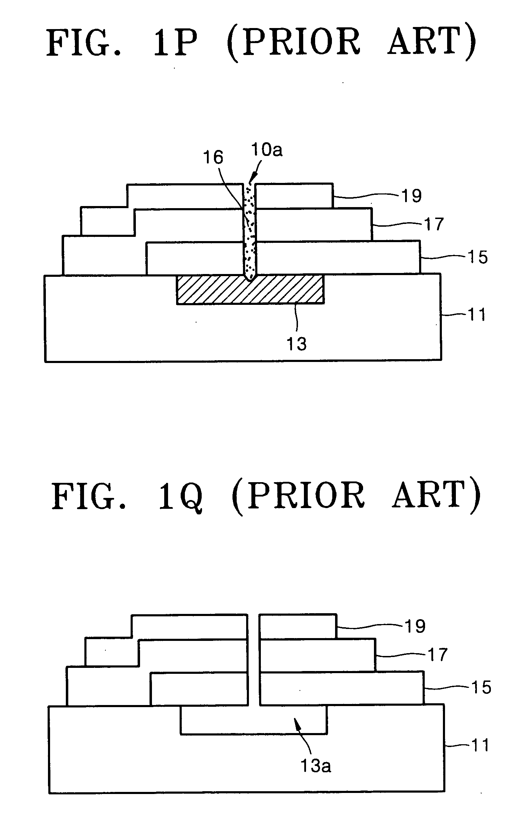

FIG. 1A through 1Q show steps for manufacturing an existing air gap type FBAR.

As shown in FIG. 1A, a semiconductor substrate 11 is prepared. Then, as shown in FIG. 1B, a photoresist 12 is coated on the semiconductor substrate 11, a mask is placed on the photoresist 12 and the photoresist is exposed. The mask has a pre-determined configuration so that an etching part is formed on the semiconductor substrate 11 as shown in FIG. 1C.

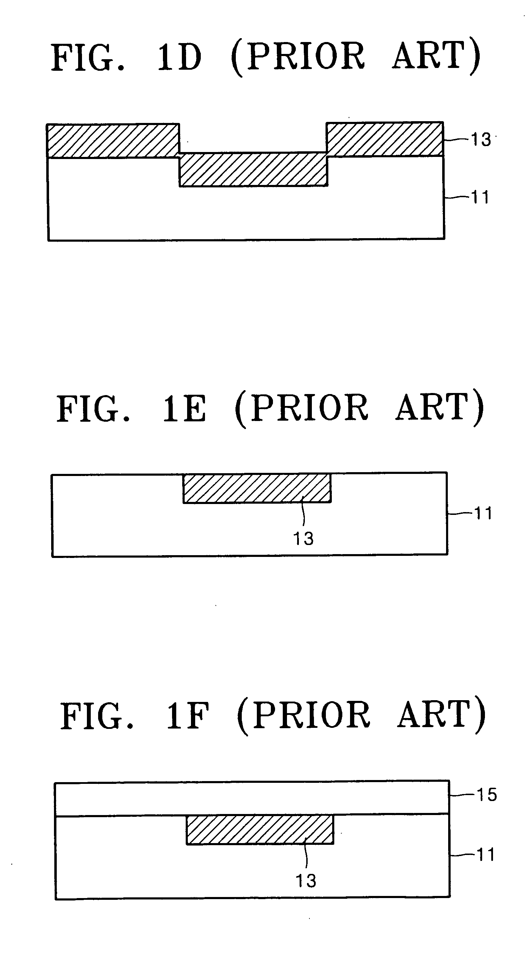

After the exposed photoresist is developed, an air gap is formed on the semiconductor substrate as shown in FIG. 1C in an Inductive Coupled Plasma Reaction Ion Etching (ICPRIE) method. Then, as shown in FIG. 1D, a sacrificial layer 13 such as poly-Si is laminated on the semiconductor substrate 11. The sacrificial layer 13 is planarized in a Chemical Mechanical Polishing (CMP) planarization process, as shown in FIG. 1E. The sacrificial layer 13 is ZnO when a piezo-electric material layer 15 is AIN. In case the piezo-electric material layer 15 is ZnO, the sacrificial layer 13 is Poly-Si.

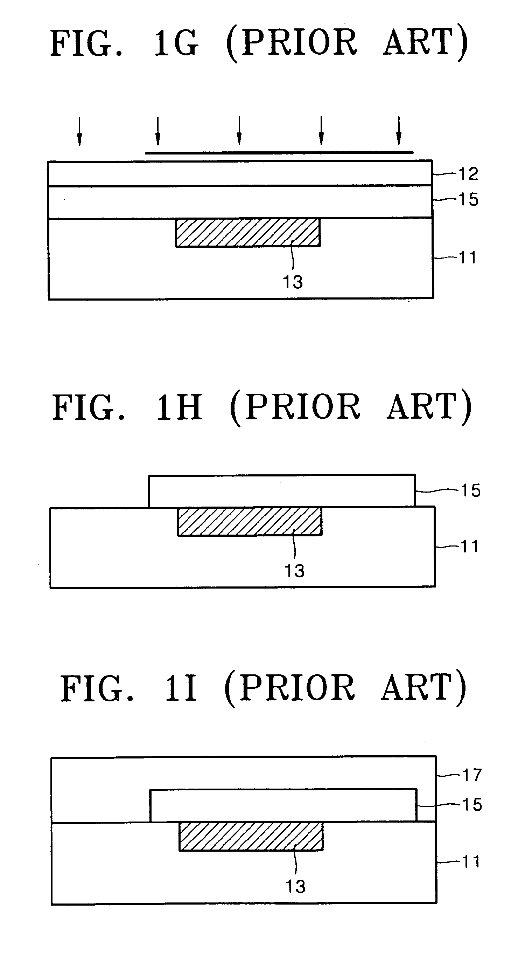

With reference to FIG. 1F, a sub-electrode 15 is laminated on the semiconductor substrate 11 including the sacrificial layer. A photo process is performed in order to pattern the laminated sub-electrode as shown in FIG. 1G. FIG. 1H shows the sub-electrode 15 formed by the photo process.

FIG. 1I shows the process of depositing a piezo-electric material layer 17 on the sub-electrode 15. The piezo-electric material layer 17 is patterned by the photo process shown in FIG. 1J. FIG. 1K shows the patterned piezo-electric material layer 17.

An upper electrode 19 is laminated on the piezo-electric material layer 17. Then, the photo process and patterning are performed as shown in FIG. 1L and 1M. FIG. 1N shows the pattern of the upper electrode 19 formed as a result of the photo process and the patterning. The sacrificial layer is still included in the semiconductor substrate.

FIG. 1O shows the step of forming a hole 10a that passes through the upper electrode 19, the piezoelectric material layer 17 and the sub-electrode 15 to eliminate the sacrificial layer. FIG. 1P shows the step of eliminating the sacrificial layer 13 by injecting an etchant 16 such as KOH into the hole 10a. The sacrificial layer can be wet-etched or dry-etched with plasma.

FIG. 1Q shows the air gap type FBAR manufactured in the above procedures.

The fabrication of the existing air gap type FBAR necessitates the above-described complicated 17 steps. In addition, in the existing air gap type FBAR fabrication method, after the semiconductor substrate is etched and the etched part needs to be filled with the sacrificial layer. Therefore, if the etched part is deep, much time is taken to fabricate the sacrificial layer and it is hard to form the deep air gap.

Moreover, an additional process of planarizing the sacrificial layer is necessary, resulting in a long complicated fabrication process, and it is difficult to planarize the sacrificial layer precisely as needed.

Especially, in the step of removing the sacrificial layer, the thin film making up the FBAR may be etched, or the wash liquid remaining in the air gap after etching of the sacrificial layer leads to defectiveness of the FBAR.

SUMMARY OF THE INVENTION

To solve the above-described problems, it is an object of the present invention to provide a Film Bulk Acoustic Resonator (FBAR) fabrication method for improving the performance of the FBAR by forming an air gap having a limitless frequency selectivity in a simplified fabrication procedure at a low cost.

To achieve the above object, there is provided an air gap type Film Bulk Acoustic Resonator (FBAR) fabrication method. The method includes: (a) depositing and patterning a sub-electrode on a semiconductor substrate; (b) depositing and patterning a piezoelectric material layer on the sub-electrode; (c) depositing and patterning an upper electrode on the piezoelectric material layer; (d) forming a hole which passes through the upper electrode, the piezoelectric material layer and the sub-electrode; and (e) injecting a fluorine compound into the hole so that an air gap can be formed on the semiconductor substrate, and non-plasma etching the semiconductor substrate.

Step (e) further includes vaporizing the fluorine compound before the fluorine compound reacts to the semiconductor substrate. Step (e) further includes performing a vacuum suction on the material generated as a result of the reaction to the fluorine compound.

It is preferable that the non-plasma etching is a chemically dry-etching.

The fluorine compound is $XeF_2$.

It is preferable that the width of the air gap is the distance from the most outer point where the upper electrode and the semiconductor substrate meet to the most outer point where the sub-electrode and the semiconductor substrate meet.

It is preferable that the depth of the air gap is half of the width of the air gap.

In the air gap type FBAR fabrication method, the present invention simplifies the fabrication processes and reduces the time and costs for the fabrication process. A non-plasma etching method using a fluorine compound can form the air gap having the limitless frequency selectivity. Therefore, because the FBAR has the air gap which has various widths and depths depending on the number of vibrations of Radio Frequency (RF), the performance of the communication system adopting the FBAR can be enhanced.

BRIEF DESCRIPTION OF THE DRAWINGS

The above object and advantages of the present invention will become more apparent by describing in detail preferred embodiments thereof with reference to the attached drawings in which:

FIGS. 1A through 1Q show a method for fabricating an existing air gap type Film Bulk Acoustic Resonator (FBAR);

FIGS. 2A through 2L show a method for fabricating FBAR according to an embodiment of the present invention;

FIG. 3 is a top view showing a filter which adopts the FBAR according to the embodiment of the present invention;

FIG. 4 shows an apparatus for fabricating the FBAR according to the embodiment of the present invention;

FIG. 5 is a photograph showing an air gap formed on a semiconductor substrate in a non-plasma etching method with a photoresist used as a mask; and

FIG. 6 is a photograph showing the air gap formed on the semiconductor substrate, where a silicon dioxide layer is deposited with the photoresist used as a mask, in the non-plasma etching method.

DETAILED DESCRIPTION OF THE INVENTION

The present invention will now be described in detail by describing preferred embodiments thereof with reference to the accompanying drawings. In the drawings, the same reference marks denote the same elements.

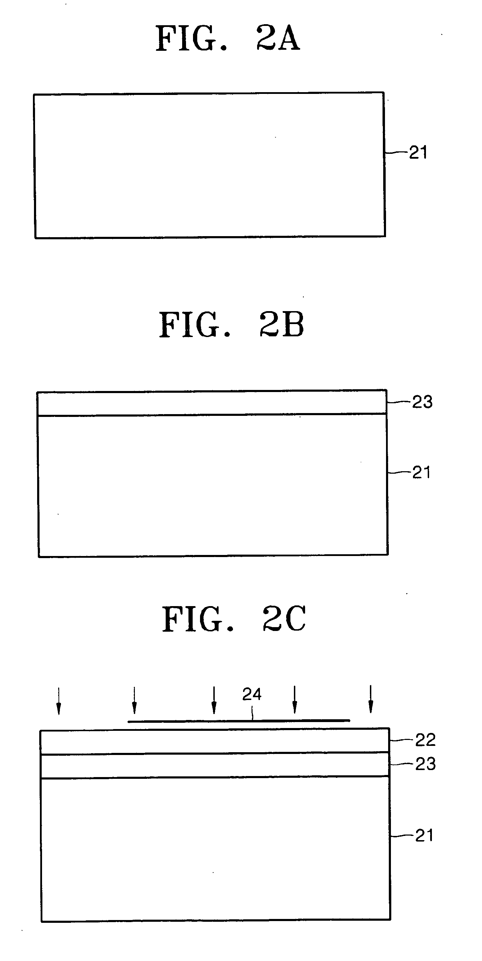

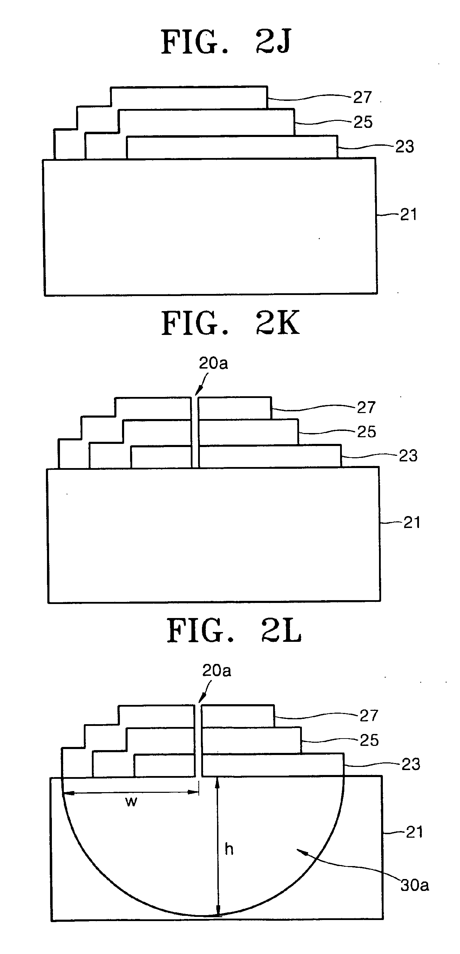

FIGS. 2A through 2L show a method for fabricating an air gap type FBAR according to an embodiment of the present invention.

For fabrication of FBAR, a semiconductor substrate 21 such as a silicon or a gallium arsenic (GaAs) is prepared as shown in FIG. 2A. A conductive electrode such as Al is laminated on the semiconductor substrate 21 to form a sub-electrode 23 as shown in FIG. 2B. The sub-electrode is patterned by a photo process as shown in FIG. 2C. In the photo process, a photoresist 22 is coated on the sub-electrode 23 and a mask of a desirable patterning configuration is placed on the photoresist 22. Then, exposure and development are performed.

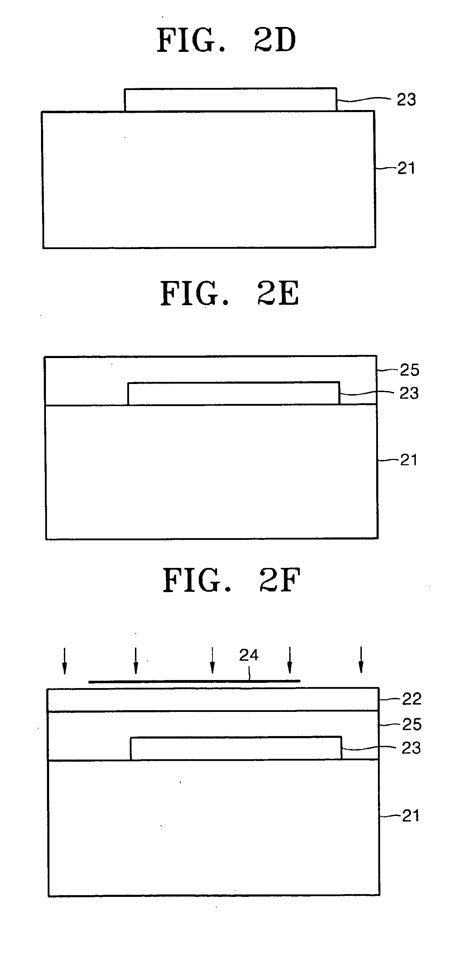

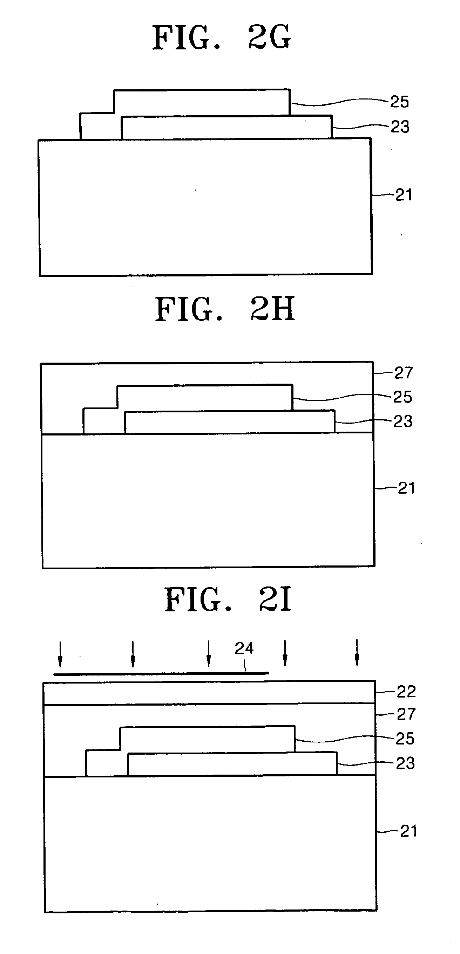

FIG. 2D shows the sub-electrode 23 patterned by the photo process. The same photo process is performed on a piezoelectric material layer 25 as shown in FIGS. 2E, 2F and 2G.

The same photo process is performed on an upper electrode 25 as shown in FIG. 2H, 2I and 2J.

FIG. 2K shows the step of forming a hole 20a which passes through the upper electrode 27, the piezoelectric material layer 25 and the sub-electrode 23 formed by the photo process. FIG. 2L shows the step of etching the semiconductor substrate 21 by injecting a fluorine compound such as $XeF_2$ into the hole 20a.

FIG. 2L shows a non-plasma etching method that uses the fluorine compound and the chemical reaction of the chemical formula 1. The fluorine compound is in a vapor state.

[Chemical Formula 1]

$$XeF_2 \rightarrow Xe + FeSi_x$$

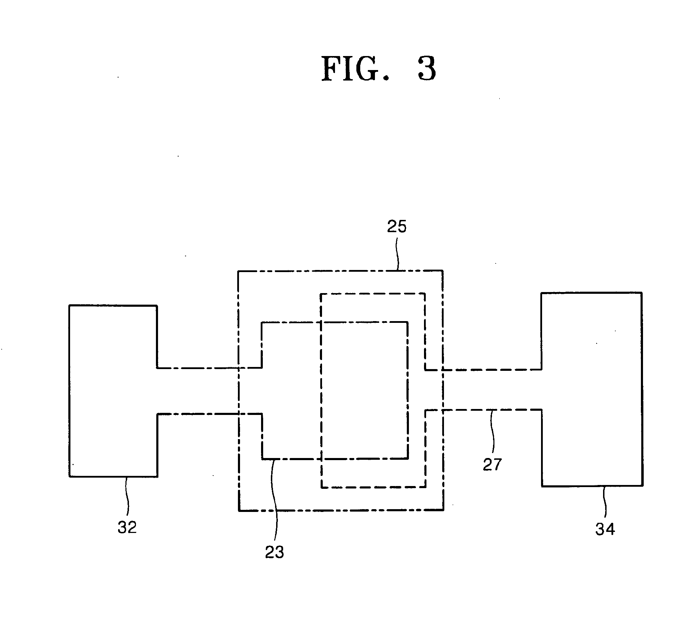

FIG. 3 is a top view showing a filter which adopts the FBAR according to the embodiment of the present invention. With reference to FIG. 3, the piezoelectric material layer 25 is prepared between the sub-electrode 23 and the upper electrode 27 that are connected to contact pads 32 and 34 respectively. Unlike the SAW filter, the FBAR filter uses a thickness wave instead of a surface wave.

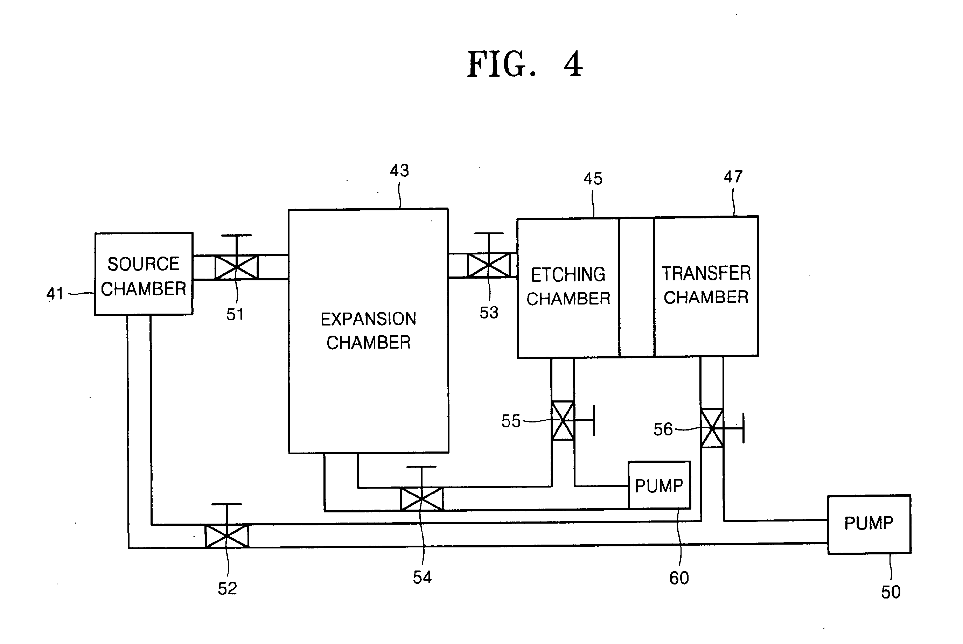

FIG. 4 shows an apparatus for fabricating the FBAR according to the embodiment of the present invention. With reference to FIG. 4, a source chamber 41 is connected with a pump 50 and an expansion chamber 43. The expansion chamber 43 is connected with a pump 60 and an etching chamber 45. The etching chamber 45 is connected with the pump 60 and a transfer chamber 47. The transfer chamber 47 is connected with the pump 50. Connection points have valves 51 through 56.

For fabrication of the air gap type FBAR according to the embodiment of the present invention, a solid fluorine compound ($XeF_2$) is prepared in the source chamber 41 and the pressure is reduced to 4torr or less. The temperature in the chamber is the normal temperature. The pressure in the chamber is reduced to 4torr or less in order to sublimate the solid fluorine compound to a vapor. In this case, the pressure needs to be adjusted appropriately so that the desirable vapor fluorine compound can be generated. With the value 51 closed, the valve 52 is opened and the pump 50 reduces the pressure in the source chamber by means of a vacuum suction and sublimates the solid fluorine compound into the vapor.

Then, with valves 51 and 54 opened, the valve 52 is closed. The pump 60 is operated to transfer the vapor fluorine compound in the chamber 41 to the expansion chamber 43. In this process, the expansion chamber 43 is filled with the vapor fluorine compound. After the chamber is filled with an appropriate amount of the fluorine compound, the valves 53 and 55 are opened and the valves 51 and 54 are closed. Then, the pump 60 is operated and transfers the vapor fluorine compound in the expansion chamber 43 to the etching chamber 45.

The etching chamber 45 has the semiconductor substrate (not shown) where the upper electrode, the sub-electrode and the piezoelectric material layer are formed. The semiconductor substrate chemically reacts to the vapor fluorine compound injected into the etching chamber 45 and is etched. The injection amounts of the fluorine compound should be adjusted depending on the size of the air gap to be formed on the semiconductor substrate. The injection amounts of the fluorine compound are adjusted depending on the chamber pressure reduced by the pump 60 that performs the vacuum suction and the opening/closing time of the valves 53 and 55. The pressure in the expansion chamber 43 is adjusted to have about 4torr and the pressure of the etching chamber 45 is adjusted to have about 20mtorr.

After the air gap of the desirable size is formed on the semiconductor substrate in the etching chamber 45, the valve 55 is opened with the value 53 closed. Then, the pump 60 is operated to discharge the remaining vapor fluorine compound.

The FBAR which passes the etching process is transferred to the transfer chamber 47.

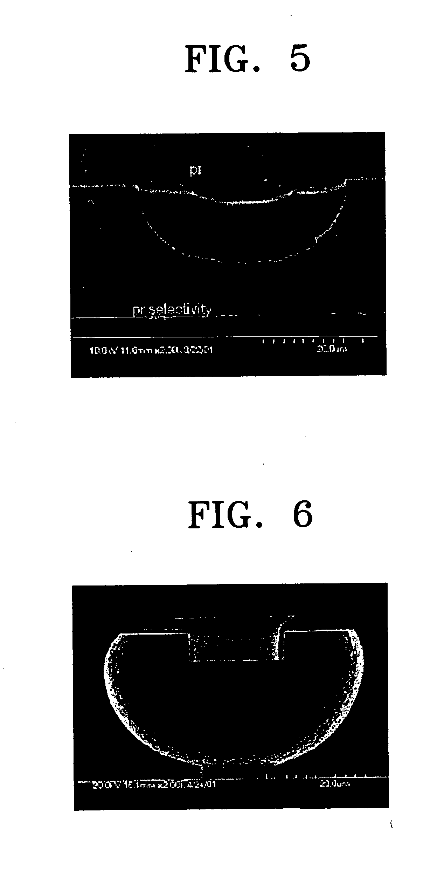

FIGS. 5 and 6 are photographs showing the air gap formed on the semiconductor substrate in the non-plasma etching method using the fluorine compound. With reference to FIG. 5, when the photoresist is used as the mask, a hemisphere air gap is formed in the lower side of the photoresist. At this time, the photoresist does not experience any damage and the desirable hemisphere air gap is formed on the semiconductor substrate. That is, the air gap type FBAR fabrication method according to the embodiment of the present invention causes no damage to the sub-electrode unlike the existing air gap type FBAR fabrication method.

FIG. 6 is a photograph showing the air gap formed on the semiconductor substrate, where a silicon dioxide layer is deposited with the photoresist used as a mask, in the non-plasma etching method. With reference to FIG. 6, the silicon dioxide layer is deposited on the semiconductor substrate, and the photoresist is coated on the silicon dioxide layer. Then, after the non-plasma etching is performed, the desirable hemisphere air gap is formed on the lower side of the silicon dioxide layer.

Since the air gap type FBAR fabrication method according the embodiment of the present invention does not require a sacrificial layer, the fabrication process is simplified, and the sub-electrode has a high adhesive power and a low resistance. As a result, the quality factor (Q) of the chip connected to the FBAR is enhanced.

In addition, according to the air gap type FBAR fabrication method of the present invention, the air gap is formed in the non-plasma etching with the fluorine compound having the limitless selectivity used. Therefore, the size of the air gap can vary according the frequency and the sub-electrode experiences no damage.

In addition, because the air gap type FABR fabrication method according to the embodiment of the present invention uses a vapor, additional cleaning process or dry process is not required, and no etchant remains and the defectiveness can be minimized.

As described above, the air gap type FBAR fabrication method according to the present invention simplifies the fabrication process and reduces the fabrication time drastically. The air gap is formed in the non-plasma etching with the fluorine compound having the limitless selectivity used. Therefore, the sub-electrode has a high adhesive power and a low resistance, and the performance of the FBAR can be enhanced.

## Claims

1. An air gap type Film Bulk Acoustic Resonator (FBAR) fabrication method comprising:

   (a) depositing and patterning a sub-electrode (23) on a semiconductor substrate (21);
   (b) depositing and patterning a piezoelectric material layer (25) on the sub-electrode (23);
   (c) depositing and patterning an upper electrode (27) on the piezoelectric material layer (25);
   (d) forming a hole (20a) which passes through the upper electrode (27), the piezoelectric material layer (25) and the sub-electrode (23); and
   (e) injecting a fluorine compound into the hole (20a) so that an air gap (30a) can be formed on the semiconductor substrate (21), and non-plasma etching the semiconductor substrate (21).

2. The method of claim 1, wherein step (e) further comprises:

   vaporizing the slid fluorine compound before the fluorine compound reacts to the semiconductor substrate (21).

3. The method of claim 2, wherein step (e) further comprises:

   performing a vacuum suction on the material generated as a result of the reaction to the fluorine compound.

4. The method of claim 3, wherein the non-plasma etching is a chemically dry-etching.

5. The method of claim 3 or 4, wherein the fluorine compound is $XeF_2$.

6. The method of claim 1, wherein the width (2W) of the air gap (30a) is the distance from the most outer point where the upper electrode (27) and the semiconductor substrate (21) meet to the most outer point where the sub-electrode (23) and the semiconductor substrate (21) meet.

7. The method of claim 1, wherein the depth (4) of the air gap (30a) is half of the width (2W) of the air gap (30a).

# FIG. 1A (PRIOR ART)

—11

# FIG. 1B (PRIOR ART)

—12
—11

# FIG. 1C (PRIOR ART)

—11

# FIG. 1D (PRIOR ART)

13

11

# FIG. 1E (PRIOR ART)

11

13

# FIG. 1F (PRIOR ART)

15

11

13

# FIG. 1G (PRIOR ART)

- 12
- 15
- 11

13

# FIG. 1H (PRIOR ART)

- 15
- 11

13

# FIG. 1I (PRIOR ART)

- 17
- 15
- 11

13

## FIG. 1J (PRIOR ART)

## FIG. 1K (PRIOR ART)

## FIG. 1L (PRIOR ART)

# FIG. 1M (PRIOR ART)

19
17
15
13
11

# FIG. 1N (PRIOR ART)

19
17
15
13
11

# FIG. 1O (PRIOR ART)

10a
19
17
15
13
11

# FIG. 1P (PRIOR ART)

# FIG. 1Q (PRIOR ART)

# FIG. 2A

21

# FIG. 2B

23

21

# FIG. 2C

24

22

23

21

# FIG. 2D

23

21

# FIG. 2E

25
23

21

# FIG. 2F

24

22
25
23

21

# FIG. 2G

# FIG. 2H

# FIG. 2I

# FIG. 2J

27
25
23

21

# FIG. 2K

20a

27
25
23

21

# FIG. 2L

20a

27
25
23

w

h

21

30a

# FIG. 3

FIG. 4

# FIG. 5

# FIG. 6